# DEMANDE DE BREVET EUROPEEN

(11) **EP 4 564 672 A1**
(43) Date de publication de la demande: **04.06.2025**
(21) Numéro de dépôt: 24216534.8
(22) Date de dépôt: 29.11.2024
(51) Int. Cl.: H03K 17/082, H02H 3/08

(54) **APPAREILLAGE DE PROTECTION A COUPURE ÉLECTRONIQUE**

(30) Priorité: 30.11.2023 FR 2313368
(71) Demandeur: Hager Next, 67210 Obernai (FR)
(72) Inventeur: GACEUS, Vincent, 67210 OBERNAI (FR); ZEISSLOFF, Thibaut, 67210 BERNARDSWILLER (FR)
(74) Mandataire: Cabinet Nuss

(57) **Abrégé**

L'invention concerne un appareillage de protection à coupure électronique comprenant: une ligne de courant de phase (P), un capteur de courant comprenant au moins un tore (4) configuré pour mesurer le courant circulant dans ladite ligne de courant de phase (P), une unité de coupure électronique (5) comprenant au moins un composant électronique de coupure de puissance (6) disposé sur ladite ligne de courant de phase (P), un déclencheur électronique de protection, une plaque conductrice de phase (7) formant d'une part une partie de la ligne de courant de phase (P) et d'autre part un dissipateur thermique (8) et étant reliée électriquement et thermiquement à ladite unité de coupure électronique (5), caractérisé en ce que la plaque conductrice de phase (7) comprend une première portion conductrice de mesure (9), la plaque conductrice de phase (7) et la première portion conductrice de mesure (9) étant une première pièce conductrice monobloc (10), et en ce que le tore (4) est disposé autour de la première portion conductrice de mesure (9).

## Description

L'invention concerne le domaine des appareillages de protection à coupure électronique.

Des appareillages de protection à coupure électronique sont connus par exemple de la publication WO2022106527A1 ou de la publication WO22243456 A1.

La publication WO22243456 A1 divulgue un circuit électronique de commande qui est configuré pour commuter les interrupteurs de puissance vers un état ouvert lorsqu'un défaut électrique est détecté par un circuit de mesure se présentant sous la forme de capteurs de courant couplés à chaque ligne de connexion. Dans ces documents, il est notamment question de trouver une solution permettant d'évacuer efficacement la chaleur dégagée par les composant électronique de coupure de puissance, de type transistor de puissance.

La publication WO2022106527 A1 divulgue également un capteur de mesure de courant pouvant consister en un tore de mesure différentiel. Toutefois, le tore de mesure différentiel est habituellement traversé par les câbles d'alimentation de la ligne de courant de neutre et de la ligne de courant de phase, ce qui a pour conséquence de compliquer l'assemblage de l'appareillage de protection à coupure électronique, car cette opération de passage des câbles d'alimentation requiert de la minutie et la réalisation de points de soudure.

Les documents WO2022243419A1, US2011/115585A1, EP2256757A1 et US2020/035425A1 divulguent des appareillages de protection de l'art antérieur.

La présente invention a pour but de pallier au moins l'un de ces inconvénients et vise à proposer une solution alternative à l'art antérieur connu permettant de faciliter l'assemblage de l'appareillage de protection à coupure électronique.

A cet effet, l'invention concerne un appareillage de protection à coupure électronique selon la revendication 1.

L'invention sera mieux comprise, grâce à la description ci-après, qui se rapporte à plusieurs modes de réalisation préférés, donnés à titre d'exemple non limitatifs, et expliqués avec référence aux dessins schématiques annexés, dans lesquels :
[Fig. 1] la figure 1 représente une vue en perspective et partielle d'un appareillage de protection à coupure électronique selon l'invention, et
[Fig. 2] la figure 2 représente une vue en perspective, en éclaté et partielle de l'appareillage de protection à coupure électronique selon l'invention.

L'invention concerne un appareillage de protection à coupure électronique comprenant au moins :
- un boîtier 1,
- une ligne de courant de phase P entre une première borne de raccordement de phase 2 et une deuxième borne de raccordement de phase 3,
- un capteur de courant comprenant au moins un tore 4 configuré pour au moins mesurer le courant circulant dans ladite ligne de courant de phase P et pour émettre au moins un signal d'acquisition représentatif de l'image du courant circulant dans ladite au moins une ligne de courant de phase P,
- une unité de coupure électronique 5 comprenant au moins un composant électronique de coupure de puissance 6 disposé sur ladite ligne de courant de phase P,
- un déclencheur électronique de protection comprenant au moins une unité de commande reliée électriquement avec ledit capteur de courant et couplée à ladite unité de coupure électronique 5 laquelle est configurée pour au moins traiter ledit signal d'acquisition et le cas échéant pour émettre un signal de commande de déclenchement de protection représentatif de l'apparition d'un défaut pour piloter l'ouverture dudit au moins un composant électronique de coupure de puissance 6 en cas d'apparition d'un défaut,
- une plaque conductrice de phase 7 formant d'une part une partie de la ligne de courant de phase P et d'autre part un dissipateur thermique 8 et étant reliée électriquement et thermiquement à ladite unité de coupure électronique 5 de sorte à dissiper la chaleur provenant dudit au moins un composant électronique de coupure de puissance 6 au moins par conduction thermique et à conduire le courant à destination de ladite unité de coupure électronique 5.

Conformément à l'invention, l'appareillage de protection à coupure électronique est caractérisé en ce que la plaque conductrice de phase 7 comprend une première portion conductrice de mesure 9, la plaque conductrice de phase 7 et la première portion conductrice de mesure 9 étant une première pièce conductrice monobloc 10, et
en ce que le tore 4 est disposé autour de la première portion conductrice de mesure 9.

Avantageusement, dans cette configuration on tire parti de la présence de la plaque conductrice de phase 7 formant d'une part une partie de la ligne de courant de phase P et d'autre part un dissipateur thermique 8 pour positionner le tore 4 dans le boîtier 1 au niveau de la première portion conductrice de mesure 9 qui fait partie de cette plaque conductrice de phase 7. Dans cette configuration le tore 4 n'est pas disposé autour de câble ou de tresse électrique formant la ligne de courant de phase P. Il en résulte une simplification de l'architecture de l'appareillage de protection à coupure électronique et de son assemblage. En effet, comparativement à un câble électrique ou une tresse électrique, la première portion conductrice de mesure 9 est davantage rigide ce qui facilite également le passage au travers du tore 4 et donc l'assemblage.

On notera également que la plaque conductrice de phase 7 permet d'évacuer la chaleur provenant dudit au moins un composant électronique de coupure de puissance 6 vers la deuxième borne de raccordement de phase 3 par conduction thermique.

De préférence, l'appareillage de protection à coupure électronique comprend un mécanisme d'isolation galvanique comprenant un premier ensemble de contacts 11 avec un premier contact fixe 12 et un premier contact mobile 13 disposés sur la ligne de courant de phase P reliés en série avec ledit au moins un composant électronique de coupure de puissance 6 et la première portion conductrice de mesure 9 comprend et de préférence forme ledit premier contact fixe 12.

Avantageusement, dans ce cas la première portion conductrice de mesure 9 réalise à la fois une fonction de positionnement du tore 4 dans le boîtier 1 et une fonction de contact fixe. Il en résulte une réduction du nombre de pièces et donc une simplification de l'architecture de l'appareillage de protection à coupure électronique et de son assemblage.

Préférentiellement, l'appareillage de protection à coupure électronique comprend en outre une ligne de courant de neutre N entre une première borne de raccordement de neutre 14 et une deuxième borne de raccordement de neutre 15 et le tore 4 est un tore différentiel et est traversé par la ligne de courant de neutre N pour en outre mesurer la différence de courant circulant entre ladite ligne de courant de phase P et la ligne de courant de neutre N et émettre un signal d'acquisition représentatif de la différence de courant entre la ligne de courant de phase P et la ligne de courant de neutre N.

Dans ce cas, l'appareillage de protection à coupure électronique peut intégrer une fonction de détection de défaut différentiel.

De préférence, la première/deuxième borne de raccordement de neutre 14, 15 comprend une pièce conductrice 16 comprenant au moins une portion de contact 17 configurée pour venir au contact avec un conducteur d'alimentation de distribution électrique du réseau ou d'une charge, la pièce conductrice 16 de la première borne de raccordement de neutre 14 est prolongée par une plaque conductrice de neutre 18 formant au moins une partie de la ligne de courant de neutre N, la plaque conductrice de neutre 18 comprend une deuxième portion conductrice de mesure 19, la pièce conductrice 16, la plaque conductrice de neutre 18 et la deuxième portion conductrice de mesure 19 étant une deuxième pièce conductrice monobloc 20, et le tore 4 est disposé autour de la première portion conductrice de mesure 9 et de la deuxième portion conductrice de mesure 19 lesquelles étant parallèles entre elles et à distance l'une de l'autre.

Avantageusement, dans cette configuration on tire en plus parti de la présence de la plaque conductrice de neutre 18 formant au moins une partie de la ligne de courant de neutre pour positionner le tore 4 dans le boîtier 1 au niveau de la deuxième portion conductrice de mesure 19 qui fait partie de cette plaque conductrice de neutre 18. Dans cette configuration, le tore 4 n'est pas disposé autour de câble ou de tresse électrique formant la ligne de courant de neutre N. Il en résulte une simplification de l'architecture de l'appareillage de protection à coupure électronique et de son assemblage. En effet, comparativement à un câble électrique ou une tresse électrique, la deuxième portion conductrice de mesure 19 est davantage rigide ce qui facilite également le passage au travers du tore 4 et donc l'assemblage. Par ailleurs, la première portion conductrice de mesure 9 et la deuxième portion conductrice de mesure 19 étant distantes l'une de l'autre, la distance d'isolement diélectrique entre le potentiel de phase et le potentiel de neutre est respectée.

De préférence, la deuxième portion conductrice de mesure 19 est formée par une extrémité de la plaque conductrice de neutre 18 située à l'opposé de la pièce conductrice 16.

Par cette configuration avantageuse, la plaque conductrice de neutre 18 permet tout comme la plaque conductrice de phase 7 de positionner le tore 4 dans le boîtier 1 autour la deuxième portion conductrice de mesure 19 et de la première portion conductrice de mesure 9 et donc de permettre de mesurer toute différence de courant entre la ligne de courant de phase P et la ligne de courant de neutre N.

De préférence, le mécanisme d'isolation galvanique comprenant en outre un deuxième ensemble de contacts 21 avec un deuxième contact fixe 22 et un deuxième contact mobile 23 disposés sur la ligne de courant de neutre N et la deuxième portion conductrice de mesure 19 comprend et de préférence forme ledit deuxième contact fixe 22.

Avantageusement, dans ce cas la deuxième portion conductrice de mesure 19 réalise à la fois une fonction de positionnement du tore 4 et une fonction de contact fixe. Il en résulte une réduction du nombre de pièces et donc une simplification de l'architecture de l'appareillage de protection à coupure électronique et de son assemblage.

De préférence, l'appareillage de protection à coupure électronique comprend au moins un compartiment de phase 24 comprenant au moins la première borne de raccordement de phase 2, ladite unité de coupure électronique 5, la plaque conductrice de phase 7, et la deuxième borne de raccordement de phase 3 et un compartiment de neutre 25 comprenant au moins la première borne de raccordement de neutre 14, la plaque conductrice de neutre 18 et la deuxième borne de raccordement de neutre 15, le compartiment de phase 24 et le compartiment de neutre 25 étant séparés par une paroi séparatrice isolante 26 comprenant un passage 27 configuré pour accueillir le tore 4 traversé par la première portion conductrice de mesure 9 et la deuxième portion conductrice de mesure 19.

La création dans le boîtier 1 du compartiment de phase 24 et du compartiment de neutre 25 permet de diviser le boîtier 1 au moins en deux parties et de séparer physiquement ladite au moins une ligne de courant de phase P de la ligne de courant de neutre N pour respecter l'isolement diélectrique entre le potentiel de phase et le potentiel de neutre. Dans le cas d'un appareillage de protection à coupure électronique multipolaire comprenant plusieurs lignes de courant de phase P et une ligne de neutre N, le boîtier 1 peut comprendre autant de compartiments de phase 24 que de lignes de courant de phase P. Le passage 27 permet de recevoir le tore 4 entre le compartiment de phase 24 et le compartiment de neutre 25.

De préférence, la paroi séparatrice isolante 26 comprend une portion de positionnement 28 isolante étant saillante dans le passage 27 et étant parallèle à et intercalée entre la première portion conductrice de mesure 9 et à la deuxième portion conductrice de mesure 19.

Avantageusement, la portion de positionnement 28 permet de positionner le tore 4 et permet d'isoler la première portion conductrice de mesure 9 de la deuxième portion conductrice de mesure 19 en garantissant le respect de l'isolement diélectrique entre le potentiel de phase et le potentiel de neutre .

De préférence, la première pièce conductrice monobloc 10 est réalisée en métal et de préférence en cuivre.

De préférence, la deuxième pièce conductrice monobloc 20 est réalisée en métal et de préférence en cuivre.

De préférence, ledit au moins un composant électronique de coupure de puissance 6 comprend au moins un transistor de puissance et préférentiellement au moins un MOSFET et/ou un JFET et/ou un IGBT.

Avantageusement, grâce cette disposition de la présente invention il est possible de placer ledit au moins un composant électronique de coupure de puissance 6 du premier ensemble E1 et ledit au moins un composant électronique de coupure de puissance 6 du deuxième ensemble E2 soit sur la même face 30, 31 de la carte électronique 12 soit sur les faces 30, 31 opposées de la carte électronique 12.

De préférence, ledit au moins un composant électronique de coupure de puissance 6 du deuxième ensemble E2 est monté sur la deuxième face 31 et comprend un élément dissipateur orienté contre la deuxième face 31 et la portion conductrice de phase 7 comporte une interface de contact 32 qui est disposée en regard de la première face 30, contre celle-ci et étant alignée avec ledit au moins un composant électronique de coupure de puissance 6 du deuxième ensemble E2 et est connectée électriquement et thermiquement à la carte électronique 29 sans contact électrique et thermique direct avec ledit au moins un composant électronique de coupure de puissance 6 du deuxième ensemble E2.

Avantageusement, dans cette configuration il n'est pas nécessaire que la portion conductrice de phase 7 soit montée sur la même face de la carte électronique 29 que ledit au moins un composant électronique de coupure de puissance 6 du premier ensemble E2 pour établir la connexion électrique et thermique entre la portion conductrice de phase 7 et ledit au moins un composant électronique de coupure de puissance 6 du premier ensemble E2.

De préférence, ledit au moins un composant électronique de coupure de puissance 6 du premier ensemble E1 est monté sur la deuxième face 31 en étant adjacent dudit au moins un composant électronique de coupure de puissance 6 du deuxième ensemble E2 et comprend un élément dissipateur orienté contre la deuxième face 31.

Avantageusement, dans ce cas ledit au moins un composant électronique de coupure de puissance 6 du premier ensemble E1 et ledit au moins un composant électronique de coupure de puissance 6 du deuxième ensemble E2 sont montés sur la même face à savoir la deuxième face 31.

Le boîtier 1 présente de préférence une forme globalement parallélépipédique avec une première face principale (non représentée) et une deuxième face principale (non représentée), et des faces latérales, respectivement arrière 33, supérieure 34, inférieure 35, avant (non représentée) s'étendant de l'une à l'autre des première et deuxième faces principales et avec une largeur, c'est-à-dire l'écart entre les première et deuxième faces principales, égale à un nombre entier de fois une distance prédéterminée, appelée module valant généralement environ 18 millimètres.

Grâce à cette disposition avantageuse, le format du boîtier 1 est modulaire et il en résulte un appareillage de protection à coupure électronique modulaire.

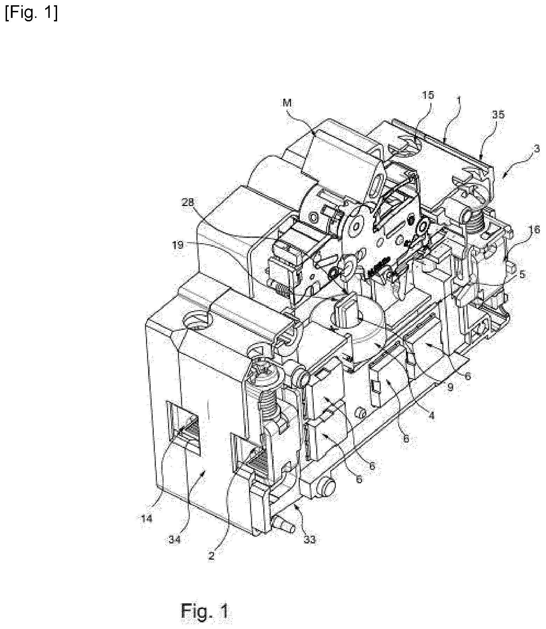

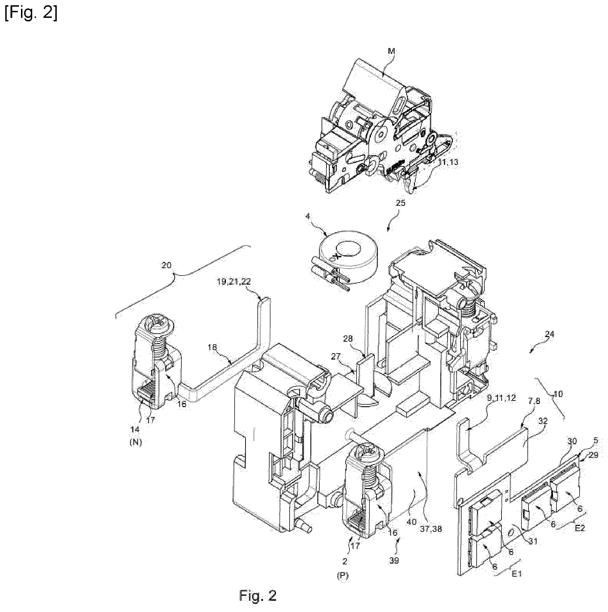

L'appareillage de protection à coupure électronique représenté aux figures 1 à 2 présente une largeur de deux modules. Cet exemple n'est pas limitatif.

L'appareillage de protection à coupure électronique modulaire peut être un disjoncteur modulaire statique du type SCCB (Semi Conductor Circuit Breaker) ou un disjoncteur différentiel modulaire statique SC-RCBO (Semi Conductor Residual current Circuit Breaker with Overload).

L'appareillage de protection à coupure électronique peut comprendre une ligne de courant de phase P, ou plusieurs lignes de courant de phase P, et de manière optionnelle en outre une ligne de courant de neutre. Les figures 1 à 2 illustrent un appareillage de protection à coupure électronique avec une ligne de courant de phase P et une ligne de courant de neutre N.

L'appareillage de protection à coupure électronique peut être un disjoncteur ou réaliser une fonction de protection de disjoncteur différentiel, mais également d'autres fonctionnalités par exemple la mesure de courant et de la tension, la protection contre les défauts d'arcs électriques dans l'installation.

Lorsque l'appareillage de protection à coupure électronique réalise une fonction de protection de disjoncteur différentiel, il comprend nécessairement le tore 4 qui est un tore différentiel permettant de détecter des défauts de type défauts différentiels et qui est relié à l'unité de commande.

La première borne de raccordement de phase 2 et la première borne de raccordement de neutre 14 peuvent être une borne à cage à vis ou une borne de serrage automatique de type ressort ou similaire. Dans les exemples illustrés dans les figures la première borne de raccordement de phase 2 et la première borne de raccordement de neutre 14 sont chacune une borne à cage à vis et sont disposées à l'intérieur du boîtier 1 à proximité de la face latérale supérieure 34.

La deuxième borne de raccordement de phase 3 et la deuxième borne de raccordement de neutre 15 peuvent être une borne à cage à vis ou une borne serrage automatique de type ressort ou similaire et/ou mixte de type cage à serrage automatique et vis. Dans les exemples illustrés dans les figures la deuxième borne de raccordement de phase 3 et la deuxième borne de raccordement de neutre 15 sont chacune une borne mixte de type cage à serrage automatique et vis et sont disposées à l'intérieur du boîtier 1 à proximité de la face latérale inférieure 35.

Dans le cas d'une première borne de raccordement de phase 2 ou d'une première borne de raccordement de neutre 14 à cage à vis illustrées dans les figures 1 à 2, les premières bornes de raccordement de phase 2 ou de neutre 14 comprennent chacune une pièce conductrice 16 comprenant au moins une portion de contact 17 configurée pour venir au contact avec un conducteur d'alimentation du réseau ou d'une charge. Les deux pièces conductrices 16 sont disposées à l'intérieur du boîtier 1 à proximité de la face latérale supérieure 34.

Le tore 4 est de préférence disposé à la fois dans le compartiment de phase 24 et dans le compartiment de neutre 25 du boîtier 1. L'axe du tore 4 est de préférence perpendiculaire à la face latérale arrière 33 et la face latérale avant et est de préférence dans le plan de la paroi séparatrice isolante 26. Le tore 4 est disposé dans le passage 27.

Le tore 4 peut être seulement autour de la première portion conductrice de mesure 9 pour mesurer seulement le courant circulant dans la ligne de courant de phase P. Dans ce cas, le déclencheur électronique de protection peut déclencher l'unité de coupure électronique 5 en cas de défaut de type surintensité ou de type court-circuit ou de type arc électrique.

L'unité de commande (non représentée) du déclencheur électronique de protection est reliée électriquement à l'unité de coupure électronique 5. L'unité de commande et l'unité de coupure électronique 5 sont disposées à l'intérieur du boîtier 1. Par exemple, l'unité de commande peut comprendre au moins un microcontrôleur et au moins un driver de puissance.

L'unité de commande et l'unité de coupure électronique 5 peuvent respectivement comprendre une ou plusieurs cartes électroniques. L'unité de commande et l'unité de coupure électronique 5 pourraient comprendre de manière alternative une unique carte électronique comprenant ledit microcontrôleur et ledit driver de puissance et ledit au moins un composant électronique de coupure de puissance 6. Dans l'exemple illustré dans les figures l'unité de coupure électronique 5 et l'unité de commande ne sont pas regroupées sur une même carte électronique, mais sur au moins deux cartes électroniques distinctes connectées électriquement et mécaniquement entre elles, seule la carte électronique 29 est représentée.

Dans ce cas, l'unité de coupure électronique 5 comporte la carte électronique 29 sur laquelle est monté et de préférence intégré ledit au moins un composant électronique de coupure de puissance 6. La carte électronique 29 est disposée dans le compartiment de phase 24 de préférence parallèlement aux première et deuxième faces principales du boîtier 1 et à la paroi séparatrice isolante 26 et s'étend dans le sens de la longueur dans un espace situé entre les première et deuxième bornes de raccordement de phase 2, 3, dans le sens de la largeur dans un espace situé entre la face latérale arrière 33 et la face latérale avant, et dans le sens de l'épaisseur dans un espace situé entre la deuxième face principale et la paroi séparatrice isolante 26. Dans l'exemple illustré dans les figures, la carte électronique 29 est préférentiellement disposée au moins en partie en regard de la deuxième face principale.

Le premier ensemble E1 de composants électroniques de coupure de puissance 6 et le deuxième ensemble E2 de composants électroniques de coupure de puissance 6 sont de préférence montés en série, par exemple de façon tête-bêche, sur la ligne de courant de phase P.

Dans l'exemple illustré, le premier ensemble E1 et le deuxième ensemble E2 comptent chacun deux composants électroniques de coupure de puissance 6. Cet exemple n'est pas limitatif. Le premier ensemble E1 comprend au moins deux composants électroniques de coupure de puissance 6 dans le même sens et montés en parallèle. Le deuxième ensemble E2 comprend au moins deux composants électroniques de coupure de puissance 6 dans le même sens et montés en parallèle.

L'élément dissipateur (non représenté) du composant électronique de coupure de puissance 6 est généralement en métal, par exemple en aluminium anodisé.

Il peut être fixé sur un corps en céramique ou en plastique de préférence moulé du composant électronique de coupure de puissance 6.

Dans ce cas, l'élément dissipateur peut être sous la forme d'une plaque métallique, correspondant au drain du composant électronique de coupure de puissance 6, laquelle est disposée à l'opposé d'un face isolée 36. Selon les types de composants électroniques de coupure de puissance 6, le drain peut en outre réaliser une fonction de connexion électrique avec un élément dissipateur rapporté décrit ci-après. Cela peut par exemple être le cas lorsque le drain est situé au niveau de la face du composant électronique de coupure de puissance 6, pouvant être la face supérieure, ne reposant pas contre une des faces 30, 31 de la carte électronique 29. Toutefois, lorsque le drain est situé sur la face du composant électronique de coupure de puissance 6, pouvant être la face inférieure, qui repose sur une des faces 30, 31 de la carte électronique 29, le drain ne réalise pas de fonction de connexion électrique avec un élément dissipateur rapporté.

De manière alternative, l'élément dissipateur peut être une pièce distincte et rapportée au composant électronique de coupure de puissance 6 et notamment ne correspondant pas au drain. L'élément dissipateur peut être dans ce cas sous la forme d'une pièce munie d'une pluralité d'ailettes. Soit cet élément dissipateur n'est pas en contact électrique avec le drain du composant électronique de coupure de puissance 6 et est monté sur la face isolée 36, soit cet élément dissipateur peut être en contact électrique avec le drain du composant électronique de coupure de puissance 6. Il en résulte que dans cette variante, le drain doit être situé au niveau de la face du composant électronique de coupure de puissance 6 ne reposant pas contre une des faces 30, 31 de la carte électronique 29.

La plaque conductrice de phase 7 formant un dissipateur thermique 8 peut se présenter de préférence sous la forme d'une pièce plane ou plaque plane avec ou sans une zone de pliage. De préférence, la pièce plane ou plaque plane est disposée dans le boîtier 1 dans le compartiment de phase 24 parallèlement aux première et deuxième faces principales, à la paroi séparatrice isolante 26 et à la carte électronique 29. La pièce plane ou plaque plane s'étend dans le sens de la longueur dans un espace situé entre les première et deuxième bornes de raccordement de phase 2, 3, dans le sens de la largeur dans un espace situé entre la face latérale arrière 33 et la face latérale avant, et dans le sens de l'épaisseur dans un espace situé entre la deuxième face principale et la paroi séparatrice isolante 26.

On entend par première pièce conductrice monobloc 10 une pièce formée d'un seul tenant par exemple par pliage ou emboutissage par exemple d'une pièce conductrice de préférence métallique. Autrement dit, la plaque conductrice de phase 7 et la première portion conductrice de mesure 9, ne sont pas deux pièces distinctes et séparées, il n'existe pas de jonction par liaison mécanique entre deux pièces distinctes et qui serait formée entre la portion de la plaque conductrice de phase 7 et la première portion conductrice de mesure 9. La première pièce conductrice monobloc 10 est de préférence en cuivre.

La première portion conductrice de mesure 9 peut se présenter sous la forme d'une languette de préférence en métal par exemple du cuivre. La languette peut consister en une plaque métallique courbée à 90 degrés ayant une forme générale de L dont la portion la plus longue sert à recevoir le tore 4 et la portion la plus courte à former une jonction avec la plaque conductrice de phase 7. Cette languette peut être dans un plan déporté et parallèle au plan de la plaque conductrice de phase 7 afin de pouvoir être positionnée dans le passage 27 de la paroi séparatrice 26. De préférence, la languette est parallèle aux première et deuxième faces principales, à la paroi séparatrice isolante 26, à la portion de positionnement 28 et à la carte électronique 29 et est dans le compartiment de phase 24. La largeur de la languette est conçue pour permettre le passage de celle-ci au travers du diamètre intérieur du tore 4. La longueur de la languette est conçue pour traverser le tore 4 de part et d'autre de sorte que l'extrémité libre de la languette soit saillante du diamètre intérieur du tore 4 après assemblage.

Le premier contact fixe 12 est de préférence réalisé par la languette de la première portion conductrice de mesure 9. La zone de contact avec le premier contact mobile 13 étant située à l'extrémité libre de la languette.

Le premier contact mobile 13 est de préférence monté sur un porte-contact.

La plaque conductrice de neutre 18 peut se présenter de préférence sous la forme d'une pièce plane ou plaque plane avec ou sans une zone de pliage. Cette plaque conductrice de neutre 18 n'a pas de fonction dissipatrice dans l'exemple illustré, mais cette possibilité n'est pas exclue. De préférence, la pièce plane ou plaque plane est disposée dans le boîtier 1 dans le compartiment de neutre 25 parallèlement aux première et deuxième faces principales, à la paroi séparatrice isolante 26 et à la carte électronique 29. La pièce plane ou plaque plane s'étend dans le sens de la longueur dans un espace situé entre les première et deuxième bornes de raccordement de neutre 14, 15, dans le sens de la largeur dans un espace situé entre la face latérale arrière 33 et la face latérale avant, et dans le sens de l'épaisseur dans un espace situé entre la première face principale et la paroi séparatrice isolante 26

La plaque conductrice de neutre 18 se trouve dans le prolongement de la portion de contact 17 de la première borne de raccordement de neutre 14.

On entend par deuxième pièce conductrice monobloc 20 une pièce formée d'un seul tenant par exemple par pliage ou emboutissage par exemple d'une pièce conductrice de préférence métallique. Autrement dit, la portion de contact 17 de préférence conductrice et la plaque conductrice de neutre 18 ne sont pas deux pièces distinctes et séparées, il n'existe pas de jonction par liaison mécanique entre deux pièces distinctes et qui serait formée entre la portion de contact 17 et la plaque conductrice de neutre 18. La deuxième pièce conductrice monobloc 20 est de préférence en cuivre.

La deuxième portion conductrice de mesure 19 est formée de préférence par l'extrémité de la plaque conductrice de neutre 18 située à l'opposé de la pièce conductrice 16. La deuxième portion conductrice de mesure 19 peut aussi se présenter sous la forme d'une languette de préférence en métal par exemple du cuivre similaire à celle de la première portion conductrice de mesure 9 et qui peut s'insérer dans le diamètre intérieur du tore 4.

Le deuxième contact fixe 22 est de préférence réalisé par la languette de la deuxième portion conductrice de mesure 19. La zone de contact avec le deuxième contact mobile 23 étant située à l'extrémité libre de la languette.

Le deuxième contact mobile 23 est de préférence monté sur le porte-contact.

Le premier contact mobile 13 et le deuxième contact mobile 23 peuvent être actionnés par un organe de manoeuvre de type une manette M (non représenté) relié au porte-contact. Cette manette M est de préférence saillante de la face latérale avant.

La paroi séparatrice isolante 26 est de préférence dans un matériau polymère tel que du plastique. Le passage 27 présente de préférence une forme sensiblement rectangulaire.

La portion de positionnement 28 peut se présenter sous la forme d'une languette de préférence en métal dite de positionnement. Cette languette de positionnement est saillante dans le passage 27 de la paroi séparatrice 26. La largeur de la languette de positionnement est conçue pour permettre le passage de celle-ci au travers du diamètre intérieur du tore 4. La longueur de la languette de positionnement est conçue pour traverser le tore 4 de part et d'autre de sorte que l'extrémité libre de la languette soit saillante du diamètre intérieur du tore 4 après assemblage.

La première face 30 de la carte électronique 29 peut comprendre une couche conductrice (non représentée) de type piste ou plan équipotentiel qui est en contact direct d'une part avec l'interface de contact 32 de la plaque conductrice de phase 7 et d'autre part avec ledit au moins un composant électronique de coupure de puissance 6 du deuxième ensemble E2. Cette couche conductrice peut être reliée à l'interface de contact 32 par un matériau de brasure.

De préférence, l'appareillage de protection à coupure électronique comporte une portion conductrice de phase 37 formant d'une part une autre partie de la ligne de courant de phase P et d'autre part un dissipateur thermique supplémentaire 38 et étant raccordée électriquement entre la première borne de raccordement de phase 2 et la deuxième borne de raccordement de phase 3.

La portion conductrice de phase 37 formant un dissipateur thermique supplémentaire 38 peut se présenter de préférence sous la forme d'une pièce plane ou plaque plane. De préférence, la pièce plane ou plaque plane est disposée dans le boîtier 1 dans le compartiment de phase 24 parallèlement aux première et deuxième faces principales et à la carte électronique 29. En outre, la pièce plane ou plaque plane est disposée en regard de la première face 30 de la carte électronique 29 sur une zone dépourvue du deuxième ensemble E2 de composants électroniques de coupure de puissance 9 et en regard de la paroi séparatrice isolante 26.

La portion conductrice de phase 37 se trouve dans le prolongement de la pièce conductrice 16 de la première borne de raccordement de phase 2.

La pièce conductrice 16 de la première borne de raccordement de phase 2 et la portion conductrice de phase 37 peuvent former une pièce conductrice monobloc de phase supplémentaire 39.

On entend par pièce conductrice monobloc de phase supplémentaire 39 une pièce formée d'un seul tenant par exemple par pliage ou emboutissage par exemple d'une pièce conductrice de préférence métallique. Autrement dit, la pièce conductrice 16 de préférence en matériau conducteur électrique et la portion conductrice de phase 37 ne sont pas deux pièces distinctes et séparées, il n'existe pas de jonction par liaison mécanique entre deux pièces distinctes et qui serait formée entre la pièce conductrice 16 et la portion conductrice de phase 37.

Préférentiellement, la portion conductrice de phase 37 comporte une interface de contact supplémentaire 40 qui est disposée en regard de la première face 30, contre celle-ci et étant alignée avec ledit au moins un composant électronique de coupure de puissance 6 du premier ensemble E1 et est connectée électriquement et thermiquement à la carte électronique 29 sans contact électrique et thermique direct avec ledit au moins un composant électronique de coupure de puissance 6 du premier ensemble E1.

En outre, la première face 30 de la carte électronique 29 peut comprendre une couche conductrice supplémentaire (non représentée) de type piste ou plan équipotentiel qui est en contact direct d'une part avec l'interface de contact supplémentaire 40 de la portion conductrice de phase 37 et d'autre part avec ledit au moins un composant électronique de coupure de puissance 6 du premier ensemble E1. Cette couche conductrice supplémentaire peut être reliée à l'interface de contact supplémentaire 40 par un matériau de brasure.

Les figures 1 à 2 illustrent un appareillage de protection à coupure électronique de phase neutre et modulaire qui présente une largeur de deux modules et est de type disjoncteur différentiel statique. L'appareillage de protection à coupure électronique modulaire comprend le mécanisme d'isolation galvanique comprenant le premier ensemble de contacts 11 avec le premier contact fixe 12 et le premier contact mobile 13 disposés sur la ligne de courant de phase P en série avec les composants électroniques de coupure de puissance 6 et le deuxième ensemble de contacts 21 avec le deuxième contact fixe 22 et le deuxième contact mobile 23 disposés sur la ligne de courant de neutre N. La plaque conductrice de phase 7 et la première portion conductrice de mesure 9 sont sous la forme de la première pièce conductrice monobloc 10, avec la première portion conductrice de mesure 9 qui forme ledit premier contact fixe 12. La pièce conductrice 16 de la première borne de raccordement de neutre 14, la plaque conductrice de neutre 18 et la deuxième portion conductrice de mesure 19 forment la deuxième pièce conductrice monobloc 20.

La pièce conductrice 16 de la première borne de raccordement de phase 2 et la portion conductrice de phase supplémentaire 37 forment une pièce conductrice monobloc de phase supplémentaire 39.

L'intérieur du boîtier 1 est divisé en deux compartiments, à savoir le compartiment de phase 24 et le compartiment de neutre 25 par la paroi séparatrice isolante 26.

Le compartiment de phase 24 comprend la première borne de raccordement de phase 2 associée à la portion conductrice de phase 37, la plaque conductrice de phase 7 et la première portion conductrice de mesure 9 formant le premier contact fixe 12, le premier contact mobile 13, la deuxième borne de raccordement de phase 3, ladite unité de coupure électronique 5.

Le compartiment de neutre 25 comprend la première borne de raccordement de neutre 14 associée à plaque conductrice de neutre 18 et comprenant le deuxième contact fixe 22, le deuxième contact mobile 23 et la deuxième borne de raccordement de neutre 15.

La paroi séparatrice isolante 26 comprend la portion de positionnement 28 isolante et qui s'étend parallèlement à l'axe du tore 4 dans le passage 27 et est parallèle à et intercalée entre la première portion conductrice de mesure 9 et à la deuxième portion conductrice de mesure 19. Le tore 4 qui est un tore différentiel est disposé autour de la première portion conductrice de mesure 9 et de la deuxième portion conductrice de mesure 19, avec la portion de positionnement 28 entre la première portion conductrice de mesure 9 et de la deuxième portion conductrice de mesure 19. L'unité de coupure électronique 5 comprend une seule carte électronique 29 avec le premier ensemble E1 comptant deux composants électroniques de coupure de puissance 6 sur ladite ligne de courant de phase P monté sur la deuxième face 31 et le deuxième ensemble E2 comptant deux composants électroniques de coupure de puissance 6 sur ladite ligne de courant de phase P monté sur la deuxième face 31 de manière adjacente au premier ensemble E1. Les deux composants électroniques de coupure de puissance 9 du deuxième ensemble E2 sont reliés électriquement en série de façon tête-bêche avec les deux composants électroniques de coupure de puissance 9 du premier ensemble E1. Les deux composants électroniques de coupure de puissance 9 du premier ensemble E1 et du deuxième ensemble E2 comprennent chacun l'élément dissipateur (non visible) sous la forme d'une plaque orientée contre la deuxième face 31 et la face isolée 31 orientée à l'opposé. L'interface de contact 32 de la portion conductrice de phase 7 est disposée en regard de la première face 30, contre celle-ci et étant alignée avec les deux composants électroniques de coupure de puissance 6 du deuxième ensemble E2 et est connectée électriquement et thermiquement à la carte électronique 29 sans contact électrique et thermique direct avec les deux composants électroniques de coupure de puissance 6 du deuxième ensemble E2. L'interface de contact supplémentaire 40 de la portion conductrice de phase 37 est disposée en regard de la première face 30, contre celle-ci et étant alignée avec les deux composants électroniques de coupure de puissance 6 du premier ensemble E1 et est connectée électriquement et thermiquement à la carte électronique 29 sans contact électrique et thermique direct avec les deux composants électroniques de coupure de puissance 6 du premier ensemble E1.

Dans cet exemple, l'évacuation de la chaleur provenant des composants électroniques de coupure de puissance 9 du deuxième ensemble E2 est réalisée par conduction thermique dans la première pièce conductrice monobloc 10 vers la première borne de raccordement de phase 2, vers la deuxième borne de raccordement de phase 3 et vers le premier ensemble de contacts 11. L'évacuation de la chaleur provenant des composants électroniques de coupure de puissance 9 du premier ensemble E1 est réalisée par conduction thermique dans la pièce conductrice monobloc de phase supplémentaire 39 vers la première borne de raccordement de phase 2, vers la deuxième borne de raccordement de phase 3 et vers le premier ensemble de contacts 11.

Bien entendu, l'invention n'est pas limitée aux modes de réalisation décrits et représentés aux dessins annexés. Des modifications restent possibles, notamment du point de vue de la constitution des divers éléments ou par substitution d'équivalents techniques, sans sortir pour autant du domaine de protection de l'invention.

## Revendications

1. Appareillage de protection à coupure électronique comprenant au moins :
- un boîtier (1),
- une ligne de courant de phase (P) entre une première borne de raccordement de phase (2) et une deuxième borne de raccordement de phase (3),
- un capteur de courant configuré pour au moins mesurer le courant circulant dans ladite ligne de courant de phase (P) et pour émettre au moins un signal d'acquisition représentatif de l'image du courant circulant dans ladite au moins une ligne de courant de phase (P),
- une unité de coupure électronique (5) comprenant au moins un composant électronique de coupure de puissance (6) disposé sur ladite ligne de courant de phase (P),
- un déclencheur électronique de protection comprenant au moins une unité de commande reliée électriquement avec ledit capteur de courant et couplée à ladite unité de coupure électronique (5) laquelle est configurée pour au moins traiter ledit signal d'acquisition et le cas échéant pour émettre un signal de commande de déclenchement de protection représentatif de l'apparition d'un défaut pour piloter l'ouverture dudit au moins un composant électronique de coupure de puissance (6) en cas d'apparition d'un défaut,
- une plaque conductrice de phase (7) formant d'une part une partie de la ligne de courant de phase (P) et d'autre part un dissipateur thermique (8) et étant reliée électriquement et thermiquement à ladite unité de coupure électronique (5) de sorte à dissiper la chaleur provenant dudit au moins un composant électronique de coupure de puissance (6) au moins par conduction thermique et à conduire le courant à destination de ladite unité de coupure électronique (5),
**caractérisé en ce que** la plaque conductrice de phase (7) comprend une première portion conductrice de mesure (9), la plaque conductrice de phase (7) et la première portion conductrice de mesure (9) étant une première pièce conductrice monobloc (10), et
**en ce que** le capteur de courant comprend au moins un tore (4) disposé autour de la première portion conductrice de mesure (9),
**en ce qu'**il comprend un mécanisme d'isolation galvanique comprenant un premier ensemble de contacts (11) avec un premier contact fixe (12) et un premier contact mobile (13) disposés sur la ligne de courant de phase (P) reliés en série avec ledit au moins un composant électronique de coupure de puissance (6) et
**en ce que** la première portion conductrice de mesure (9) comprend et forme ledit premier contact fixe (12).

2. Appareillage de protection à coupure électronique selon la revendication 1, **caractérisé en ce qu'**il comprend en outre une ligne de courant de neutre (N) entre une première borne de raccordement de neutre (14) et une deuxième borne de raccordement de neutre (15) et **en ce que** le tore (4) est un tore différentiel et est traversé par la ligne de courant de neutre (N) pour en outre mesurer la différence de courant circulant entre ladite ligne de courant de phase (P) et la ligne de courant de neutre (N) et émettre un signal d'acquisition représentatif de la différence de courant entre la ligne de courant de phase (P) et la ligne de courant de neutre (N).

3. Appareillage de protection à coupure électronique selon la revendication 2, **caractérisé en ce que** la première/deuxième borne de raccordement de neutre (14, 15) comprend une pièce conductrice (16) comprenant au moins une portion de contact (17) configurée pour venir au contact avec un conducteur d'alimentation de distribution électrique du réseau ou d'une charge, la pièce conductrice (16) de la première borne de raccordement de neutre (14) est prolongée par une plaque conductrice de neutre (18) formant au moins une partie de la ligne de courant de neutre (N), la plaque conductrice de neutre (18) comprend une deuxième portion conductrice de mesure (19), la pièce conductrice (16), la plaque conductrice de neutre (18) et la deuxième portion conductrice de mesure (19) étant une deuxième pièce conductrice monobloc (20), et **en ce que** le tore (4) est disposé autour de la première portion conductrice de mesure (9) et de la deuxième portion conductrice de mesure (19) lesquelles étant parallèles entre elles et à distance l'une de l'autre.

4. Appareillage de protection à coupure électronique selon la revendication 3, **caractérisé en ce que** la deuxième portion conductrice de mesure (19) est formée par une extrémité de la plaque conductrice de neutre (18) située à l'opposé de la pièce conductrice (16).

5. Appareillage de protection à coupure électronique selon la revendication 3 ou la revendication 4, **caractérisé en ce que** le mécanisme d'isolation galvanique comprenant en outre un deuxième ensemble de contacts (21) avec un deuxième contact fixe (22) et un deuxième contact mobile (23) disposés sur la ligne de courant de neutre (N) et **en ce que** la deuxième portion conductrice de mesure (19) comprend et de préférence forme ledit deuxième contact fixe (22).

6. Appareillage de protection à coupure électronique selon l'une quelconque des revendication 3 à 5, **caractérisé en ce qu'**il comprend au moins un compartiment de phase (24) comprenant au moins la première borne de raccordement de phase (2), ladite unité de coupure électronique (5), la plaque conductrice de phase (7), et la deuxième borne de raccordement de phase (3) et un compartiment de neutre (25) comprenant au moins la première borne de raccordement de neutre (14), la plaque conductrice de neutre (18) et la deuxième borne de raccordement de neutre (15), le compartiment de phase (24) et le compartiment de neutre (25) étant séparés par une paroi séparatrice isolante (26) comprenant un passage (27) configuré pour accueillir le tore (4) traversé par la première portion conductrice de mesure (9) et la deuxième portion conductrice de mesure (19).

7. Appareillage de protection à coupure électronique selon la revendication 6, **caractérisé en ce que** la paroi séparatrice isolante (26) comprend une portion de positionnement (28) isolante étant saillante dans le passage (27) et étant parallèle à et intercalée entre la première portion conductrice de mesure (9) et à la deuxième portion conductrice de mesure (19).

8. Appareillage de protection à coupure électronique selon l'une quelconque des revendications 1 à 7, **caractérisé en ce que** la première pièce conductrice monobloc (10) est réalisée en métal et de préférence en cuivre

9. Appareillage de protection à coupure électronique selon l'une quelconque des revendications 3 à 8, **caractérisé en ce que** la deuxième pièce conductrice monobloc (20) est réalisée en métal et de préférence en cuivre

10. Appareillage de protection à coupure électronique selon l'une quelconque des revendications 1 à 9, **caractérisé en ce que** ledit au moins un composant électronique de coupure de puissance (6) comprend au moins un transistor de puissance et préférentiellement au moins un MOSFET et/ou un JFET et/ou un IGBT.

11. Appareillage de protection à coupure électronique selon l'une quelconque des revendications 1 à 10, **caractérisé en ce que** ladite unité de coupure électronique (5) comprend au moins une carte électronique (29) comprenant une première face (30) et une deuxième face (31) opposée à la première face (30) et **en ce que** ladite unité de coupure électronique (5) comprend un premier ensemble (E1) d'au moins un composant électronique de coupure de puissance (6) sur ladite ligne de courant de phase (P) monté sur la première face (30) ou la deuxième face (31) et un deuxième ensemble (E2) d'au moins un composant électronique de coupure de puissance (6) sur ladite ligne de courant de phase (P) monté sur la première face (30) ou la deuxième face (31) et relié électriquement en tête-bêche dudit au moins un composant électronique de coupure de puissance (6) du premier ensemble (E1).

12. Appareillage de protection à coupure électronique selon la revendication 11, **caractérisé en ce que** ledit au moins un composant électronique de coupure de puissance (6) du deuxième ensemble (E2) est monté sur la deuxième face (31) et comprend un élément dissipateur orientée contre la deuxième face (31) et **en ce que** la portion conductrice de phase (7) comporte une interface de contact (32) qui est disposée en regard de la première face (30), contre celle-ci et étant alignée avec ledit au moins un composant électronique de coupure de puissance (6) du deuxième ensemble (E2) et est connectée électriquement et thermiquement à la carte électronique (29) sans contact électrique et thermique direct avec ledit au moins un composant électronique de coupure de puissance (6) du deuxième ensemble (E2).

13. Appareillage de protection à coupure électronique selon l'une quelconque des revendications 11 à 12, **caractérisé en ce que** ledit au moins un composant électronique de coupure de puissance (6) du premier ensemble (E1) est monté sur la deuxième face (31) en étant adjacent dudit au moins un composant électronique de coupure de puissance (6) du deuxième ensemble (E2) et comprend une élément dissipateur orientée contre la deuxième face (31).
